# EUROPEAN PATENT APPLICATION

(11) **EP 2 629 418 A2**
(43) Date of publication of application: **21.08.2013**
(21) Application number: 13155469.3
(22) Date of filing: 15.02.2013
(51) Int. Cl.: H03J 1/00

(54) **Broadcast reception device**

(30) Priority: 15.02.2012 JP 2012030586
(71) Applicant: Alps Electric Co., Ltd., Tokyo 145-8501 (JP)
(72) Inventor: Tominaga, Atsushi, Tokyo 145-8501 (JP)
(74) Representative: Klunker . Schmitt-Nilson . Hirsch

(57) **Abstract**

Under the control of a controller (5), a memory (52) stores therein the frequency value of a desired signal, set by a first frequency setting circuit (39), in a state where a first tuner device (3) receives the desired signal, a second tuner device (4) sweeps a reception target band and receives a disturbing signal different from the desired signal after the amplification degree of a second amplifying device (42) has been reduced by a predetermined amount, the level of the received disturbing signal is detected by a level detection circuit (45) and stored in a memory along with a frequency value set by a second frequency setting circuit (49), and the AGC starting level of an AGC circuit (37) is set on the basis of the magnitude of each of the level and the frequency of the disturbing signal.

## Description

### BACKGROUND OF THE INVENTION

### 1. Field of the Invention

The present invention relates to a broadcast reception device whose performance to remove a disturbing signal is enhanced.

### 2. Description of the Related Art

In broadcast reception devices such as an in-car FM receiver and the like, automatic gain control (AGC) is performed so as to avoid poor reception due to a disturbing signal. Such a technique is disclosed in, for example, Japanese Unexamined Patent Application Publication No. 2009-152873. In this broadcast reception device, when a received electric field strength has become so high as to be greater than or equal to the starting level of AGC, the AGC is validated, and an amplification degree set in an amplifier is decreased and the received electric field strength is reduced by a predetermined amount. Accordingly, the received electric field strength of the disturbing signal is suppressed, and poor reception is avoided. In the broadcast reception device in Japanese Unexamined Patent Application Publication No. 2009-152873, N-AGC (narrowband AGC) where a received electric field strength is controlled in a predetermined frequency band in the vicinity of a desired signal and W-AGC (wideband AGC) where a received electric field strength is controlled in a frequency band located a predetermined frequency or more away from the desired signal are used concurrently.

### SUMMARY OF THE INVENTION

In a receiver (FM audio receiver) used for FM audio broadcast reception, a removing ability for a disturbing signal mainly depends on the starting level of AGC. The optimum level of the starting level of AGC varies according to the frequency or the received electric field strength of the disturbing signal. Therefore, if it is possible to monitor the frequency or the received electric field strength of the disturbing signal and adequately control the starting level of AGC, it may be possible to optimize the removing ability for the disturbing signal and enhance a reception performance. However, owing to the functional limitation of an FM audio receiver, it is difficult to control the starting level of AGC in response to the frequency or the received electric field strength of the disturbing signal, and in current FM audio receivers, a sufficiently high-level performance to remove a disturbing signal has not been obtained.

In view of such a point, the present invention is made, and provides a broadcast reception device whose performance to remove a disturbing signal is enhanced.

In aspect of the present invention provides a broadcast reception device having a seek function of sweeping a reception target band and detecting a desired signal, the broadcast reception device including first and second tuner devices, into each of which a reception signal from an antenna is input, and a controller controlling the first and second tuner devices, wherein the first tuner device includes a first amplifying device amplifying the reception signal from the antenna, a first frequency setting circuit setting a frequency corresponding to a signal extracted from the reception signal, and an AGC circuit controlling a level of the reception signal, the second tuner device includes a second amplifying device amplifying the reception signal from the antenna, a second frequency setting circuit setting a frequency corresponding to a signal extracted from the reception signal, and a level detection circuit detecting the level of the reception signal, the controller includes a memory storing therein a detection result of the level detection circuit and storing therein set frequency values of the first and second frequency setting circuits, and under the control of the controller, the memory stores therein a frequency value of the desired signal, set by the first frequency setting circuit, in a state where the first tuner device receives the desired signal, the second tuner device sweeps a reception target band and receives a disturbing signal different from the desired signal after an amplification degree of the second amplifying device has been reduced by a predetermined amount, a level of the received disturbing signal is detected by the level detection circuit and stored in the memory along with a frequency value set by the second frequency setting circuit, and an AGC starting level of the AGC circuit is set on the basis of a magnitude of each of the level and a frequency of the disturbing signal.

According to this configuration, since the level and the frequency of the disturbing signal are acquired owing to the second tuner device, it may be possible to adequately set the AGC starting level of the AGC circuit without putting a load on the first tuner device. In addition, since the level of the disturbing signal is detected after the amplification degree of the second amplifying device has been reduced by a predetermined amount, it may be possible to adequately detect the level of the disturbing signal and adequately set the AGC starting level of the AGC circuit. From these results, it may be possible to enhance the performance to remove the disturbing signal.

In the broadcast reception device of the present invention, when a plurality of disturbing signals are detected, it may be desirable that the AGC starting level of the AGC circuit is set by comparing a magnitude of each of levels and frequencies of the plural disturbing signals. In addition, it may be desirable that two signals serving as a basis for setting the AGC starting level of the AGC circuit are selected in response to the levels and the frequencies of the plural disturbing signals and the AGC starting level of the AGC circuit is set by comparing a magnitude of each of the levels and the frequencies of the two disturbing signals. According to these configurations, since it may be possible to set the AGC starting level of the AGC circuit on the basis of a disturbing signal suitable for setting the starting level of the AGC circuit, it may be possible to further enhance the performance to remove the disturbing signal.

In the broadcast reception device of the present invention, it may be desirable that the second tuner device reduces the amplification degree of the second amplifying device to a level where the linearity of the second amplifying device is maintainable with respect to an assumed maximum signal level of the disturbing signal. According to this configuration, since it may be possible to maintain the linearity of the second amplifying device with respect to the disturbing signal of an assumed maximum signal level, it may be possible to adequately detect the level of the disturbing signal. As a result, it may be possible to further enhance the performance to remove the disturbing signal.

In the broadcast reception device of the present invention, it may be desirable that the AGC circuit includes a narrowband AGC circuit gain-controlling a disturbing signal existing in the vicinity of the desired signal and a wideband AGC circuit gain-controlling a disturbing signal located a predetermined frequency or more away from the desired signal and an AGC starting level is set for each of the narrowband AGC circuit and the wideband AGC circuit.

In the broadcast reception device of the present invention, it may be desirable that the broadcast reception device is configured to be able to receive FM broadcast.

In the broadcast reception device of the present invention, it may be desirable that the first tuner device is a tuner device used for audio broadcast reception and the second tuner device is a tuner device used for data broadcast reception. According to this configuration, since it may be possible to detect the disturbing signal using the second tuner device serving as a tuner used for data broadcast reception, it may be possible to adequately set the AGC starting level of the AGC circuit without putting a load on the first tuner device used for audio broadcast reception.

### BRIEF DESCRIPTION OF THE DRAWINGS

Fig. 1 is a circuit block diagram illustrating an example of a configuration of a broadcast reception device according to the present embodiment;
Fig. 2 is a conceptual diagram illustrating main processing for setting a starting level of an AGC circuit in a broadcast reception device according to the present embodiment;
Fig. 3 is a flowchart illustrating detection processing for a desired signal and a disturbing signal, performed for setting a starting level;
Fig. 4 is a flowchart illustrating a portion of calculation processing for a starting level;
Fig. 5 is a flowchart illustrating another portion of the calculation processing for a starting level;
Figs. 6A and 6B are graphs illustrating relationships between an amplification degree of an LNA and an electric field strength;
Fig. 7 is a table illustrating a pattern of a starting level to be set; and
Figs. 8A to 8F are graphs illustrating relationships among a frequency and a level of a disturbing signal and a starting level of an AGC circuit.

### DESCRIPTION OF THE PREFERRED EMBODIMENTS

Hereinafter, the configuration of a broadcast reception device according to one embodiment of the present invention will be described with reference to drawings. In addition, in the following, while a broadcast reception device will be described that is simplified so as to describe the present invention, it is assumed that the broadcast reception device fully includes a configuration included in a usual broadcast reception device.

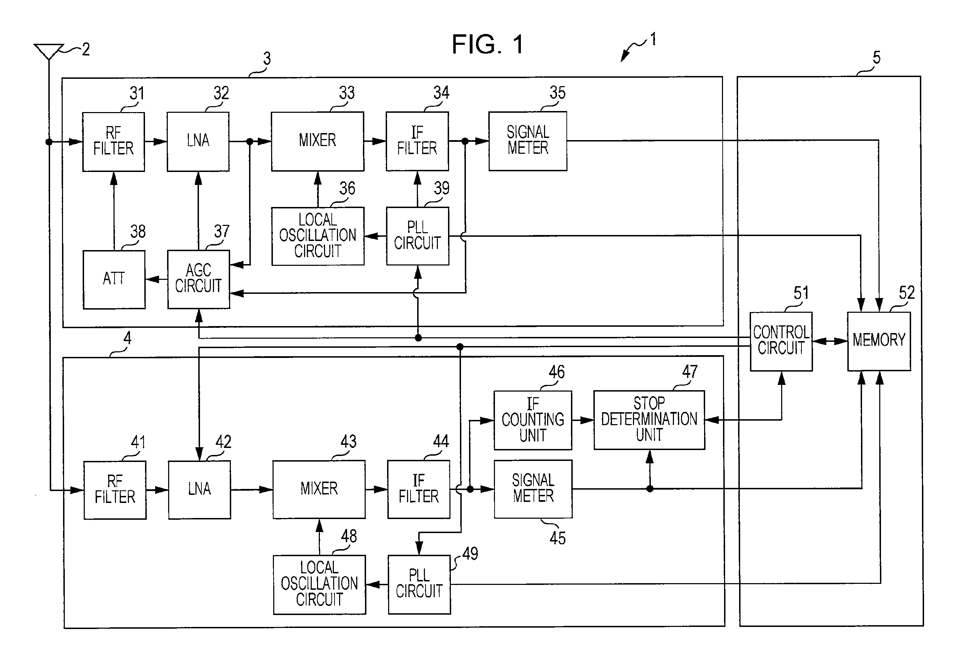

Fig. 1 is a circuit block diagram illustrating an example of the configuration of a broadcast reception device 1 according to the present embodiment. The broadcast reception device 1 according to the present embodiment includes an antenna 2, an audio broadcast receiver (first tuner device) 3 capable of receiving audio broadcast, a data broadcast receiver (second tuner device) 4 capable of receiving data broadcast, and a microcomputer (controller) 5 controlling the audio broadcast receiver 3 and the data broadcast receiver 4. The antenna 2 receives a broadcast wave broadcast from each broadcasting station, and supplies a reception RF (wireless frequency) signal to the audio broadcast receiver 3 and the data broadcast receiver 4.

The audio broadcast receiver 3 is a broadcast receiver capable of receiving FM audio broadcast. When the reception RF signal has been input from the antenna 2 to this audio broadcast receiver 3, an RF signal of a broadcast band is extracted in an RF filter 31. An LNA (first amplifying device) 32 is connected to the subsequent stage of the RF filter 31, and the extracted RF signal of a broadcast band is amplified with a low noise. In a mixer 33, the RF signal amplified in the LNA 32 is mixed with a local oscillation signal from a local oscillation circuit 36 and converted into an intermediate frequency (IF) signal. At the time of a seek operation, a signal frequency supplied from the local oscillation circuit 36 to the mixer 33 is switched in a PLL circuit 39 (first frequency setting circuit), and hence, the entire broadcast band is swept. The PLL circuit 39 is controlled by a PLL circuit control signal supplied from a control circuit 51 described later, and switches the frequency of the local oscillation signal from the local oscillation circuit 36 in response to the PLL circuit control signal. In other words, the PLL circuit control signal includes information corresponding to a set frequency.

A non-reception channel signal in the IF signal output from the mixer 33 is subjected to filtering in an IF filter 34. A reception channel signal having passed through the IF filter 34 is input to a signal meter 35. In the signal meter 35, the reception channel signal is converted into a signal-meter signal corresponding to a level (received electric field strength: RSSI).

When a user has selected a channel, the reception channel signal having passed through the IF filter 34 is demodulated in an audio demodulation unit (not illustrated), and output from a speaker (not illustrated), as an audio. The information of the signal-meter signal and the information of the set frequency of the PLL circuit 39 (for example, the PLL circuit control signal), which correspond to the channel selected by the user, are stored in a memory 52 in the microcomputer 5, as the level information and the frequency information of the desired signal, respectively.

The audio broadcast receiver 3 includes an AGC circuit 37 that detects the signal level of the reception RF signal and controls the gain of the LNA 32. This AGC circuit 37 is configured so as to include a W-AGC circuit (wideband AGC circuit) for a wide band and an N-AGC circuit (narrowband AGC circuit) for a narrow band. When a disturbing signal having an intense electric field has been detected, the AGC circuit 37 outputs a control voltage for suppressing the electric field strength of the disturbing signal in accordance with a set starting level (AGC starting level). Specifically, the W-AGC circuit for a wide band generates a direct-current voltage corresponding to an output level from the LNA 32, and outputs the direct-current voltage to the LNA 32. The N-AGC circuit for a narrow band generates a direct-current voltage corresponding to an output level from the IF filter 34, and outputs the direct-current voltage to the LNA 32.

The starting level for starting the AGC operation of the AGC circuit 37 is caused to be set in response to a disturbing signal detected in the data broadcast receiver 4, as described later. For example, when the disturbing signal within the reception RF signal has increased and the receiving sensitivity of a desired channel in the audio broadcast receiver 3 has decreased, processing for resetting the starting level of the AGC circuit 37 is performed so as to increase the receiving sensitivity. The amplification degree of the LNA 32 is controlled by an output from the AGC circuit 37. Therefore, owing to resetting the starting level of the AGC circuit 37, the disturbing signal within the broadcast wave is adequately suppressed by controlling the gain of the LNA 32, and it may be possible to enhance the receiving sensitivity of the desired channel.

In response to the control voltage of the AGC circuit 37, an attenuator (ATT) 38 attenuates the level of the reception RF signal input from the antenna 2, and operates so as to optimize the level of the reception RF signal. The direct-current voltage itself generated in the AGC circuit 37 or a direct-current voltage generated in response thereto is input to the attenuator 38.

The data broadcast receiver 4 is a broadcast receiver capable of receiving data broadcast such as a Vehicle Information and Communication System (VICS: registered trademark) or a Radio Data System (RDS). When the reception RF signal has been input to this data broadcast receiver 4, an RF signal of a broadcast band is extracted in an RF filter 41, and amplified with a low noise, in an LNA (second amplifying device) 42 in a subsequent stage. In a mixer 43, the RF signal amplified in the LNA 42 is mixed with a local oscillation signal from a local oscillation circuit 48, and converted into an IF signal. A non-reception channel signal in the IF signal output from the mixer 43 is subjected to filtering in an IF filter 44, and broadcast data within the reception channel signal is decoded in a decoder (not illustrated).

In addition, the data broadcast receiver 4 is configured to be able to detect a disturbing signal within the broadcast wave of audio broadcast using the vacant time of the reception operation of data broadcast. In an operation for detecting the disturbing signal, in the mixer 43, the RF signal amplified in the LNA 42 is mixed with the local oscillation signal from the local oscillation circuit 48, and converted into the IF signal. A signal frequency supplied from the local oscillation circuit 48 to the mixer 43 is switched in a PLL circuit (second frequency setting circuit) 49, and hence, the entire broadcast band of audio broadcast is sought, and a disturbing signal existing within the broadcast band is detected. The PLL circuit 49 is controlled by a PLL circuit control signal supplied from the control circuit 51 described later, and switches the frequency of the local oscillation signal from the local oscillation circuit 48 in response to the PLL circuit control signal. In other words, the PLL circuit control signal includes information corresponding to a set frequency.

In the operation for detecting the disturbing signal, the IF signal output from the mixer 43 is subjected to filtering in the IF filter 44, and input to a signal meter (level detection circuit) 45 and an IF counting unit 46. The reception channel signal input from the IF filter 44 is converted into a signal-meter signal corresponding to a level, in the signal meter 45. The IF counting unit 46 counts the number of pulses corresponding to the frequency of the IF signal converted in the mixer 43, and generate an IF count signal. The signal-meter signal and the IF count signal are input to a stop determination unit 47 in a subsequent stage.

In a frequency position where the signal-meter signal becomes greater than or equal to a seek threshold (threshold value), the stop determination unit 47 outputs a stop signal to the control circuit 51. The control circuit 51 causes the memory 52 to store therein the information of the signal-meter signal and the information of the set frequency of the PLL circuit 49 (for example, the PLL circuit control signal), which correspond to the stop signal, as the level information and the frequency information of the disturbing signal. In other words, owing to the stop determination unit 47, the presence or absence of a high-level disturbing signal greater than or equal to the seek threshold is determined, and the level and the frequency of the disturbing signal are stored in the memory 52.

The microcomputer 5 includes the control circuit 51 controlling the individual configurations of the audio broadcast receiver 3 and the data broadcast receiver 4 and the memory 52 storing therein the level information and the frequency information corresponding to the information of the signal-meter signal and the information of the set frequency of the PLL circuit 49. On the basis of the level information and the frequency information, stored in the memory 52, the control circuit 51 sets the starting level of the AGC circuit 37. Specifically, on the basis of the level information and the frequency information of the desired signal, acquired in the audio broadcast receiver 3 and stored in the memory 52, and the level information and the frequency information of the disturbing signal, acquired in the data broadcast receiver 4 and stored in the memory 52, the the control circuit 51 sets the starting level of the AGC circuit 37. In addition, the level information of the desired signal may not be used for setting the starting level of the AGC circuit 37.

In addition, the control circuit 51 sets, in the LNA 42, an amplification degree suitable for detecting the disturbing signal. Specifically, the control circuit 51 performs setting so that the amplification degree of the LNA 42 becomes low at the time of the operation for detecting the disturbing signal, compared with the time of an operation for receiving the data broadcast. The linear output range of the LNA 42 has been determined, and usually the amplification degree of the LNA 42 has been optimized for the operation for receiving the data broadcast. In this state, when a high-level disturbing signal is input that exceeds an upper limit where the linearity of an output is maintainable, the output of the LNA 42 is saturated, and it may be difficult to adequately detect the level of the disturbing signal. Therefore, at the time of the operation for detecting the disturbing signal, the control unit 51 sets, in the LNA 42, an amplification degree lower than at the time of the operation for receiving the data broadcast. More specifically, at the time of the operation for detecting the disturbing signal, the amplification degree of the LNA 42 is reduced to a level where the linearity of the LNA 42 is maintainable with respect to the assumed maximum signal level of the disturbing signal. Accordingly, it may be possible to adequately detect the level of the high-level disturbing signal.

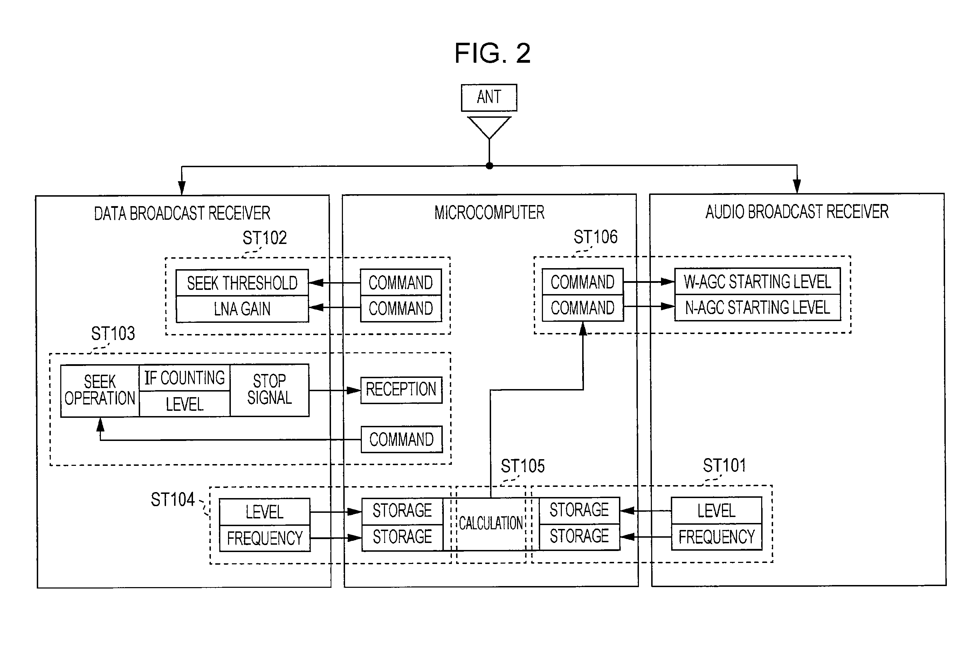

Fig. 2 is a conceptual diagram illustrating main processing performed for resetting the starting level of the AGC circuit 37 in the broadcast reception device 1 according to the present embodiment. Before the resetting processing for the starting level, the microcomputer 5 acquires the level information and the frequency information of the desired signal in a state where the audio broadcast receiver 3 receives a desired wave. In other words, the control circuit 51 causes the memory 52 to store therein the signal-meter signal and the frequency information set in the PLL circuit 39, which correspond to the channel selected in the audio broadcast receiver 3 by the user, as the level information and the frequency information of the desired signal (Step ST101). When the resetting processing for the starting level has been started, the control circuit 51 sets a seek threshold and an LNA gain, suitable for detecting the disturbing signal, in the stop determination unit 47 and the LNA 42 in the data broadcast receiver 4, respectively (Step ST102).

After that, so as to detect the disturbing signal within the broadcast wave of the audio broadcast, the entire region of the broadcast band is sought in the data broadcast receiver 4. At the time of a seek operation, in a frequency position where the signal-meter signal becomes greater than or equal to the seek threshold, the stop determination unit 47 outputs the stop signal (Step ST103). The control circuit 51 having received the stop signal causes the memory 52 to store therein the signal-meter signal and the frequency information set in the PLL circuit 49, which correspond to the stop signal, as the level information and the frequency information of the disturbing signal (Step ST104).

When the seek operation has been terminated, the control circuit 51 calculates the starting level of the AGC circuit 37 on the basis of the level information and the frequency information of the desired signal and the level information and the frequency information of the disturbing signal, stored in the memory 52 (Step ST105). In addition, the calculated starting level is set in the AGC circuit 37 (Step ST106). In this way, the broadcast reception device 1 acquires the level information and the frequency information of the disturbing signal owing to the data broadcast receiver 4, and sets the starting level of the AGC circuit 37 (namely, the starting levels of the W-AGC circuit and the N-AGC circuit) on the basis of the acquired information.

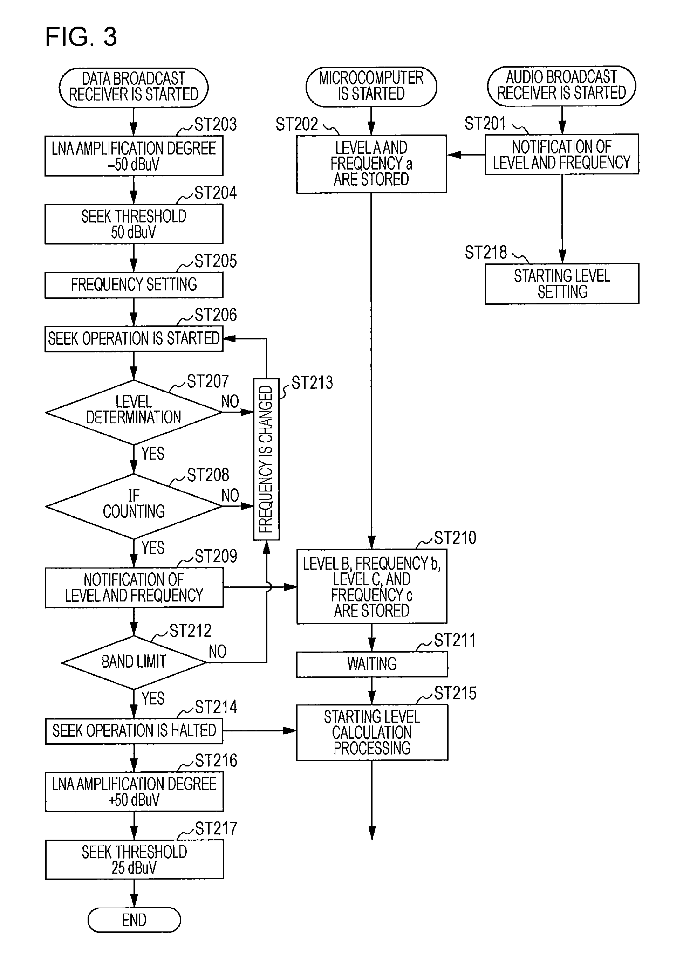

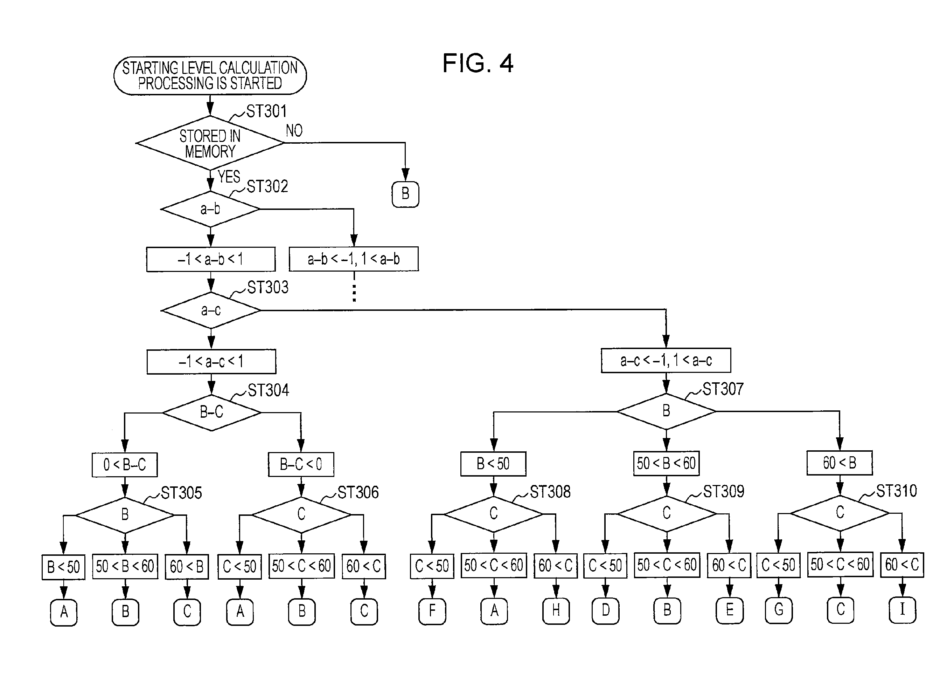

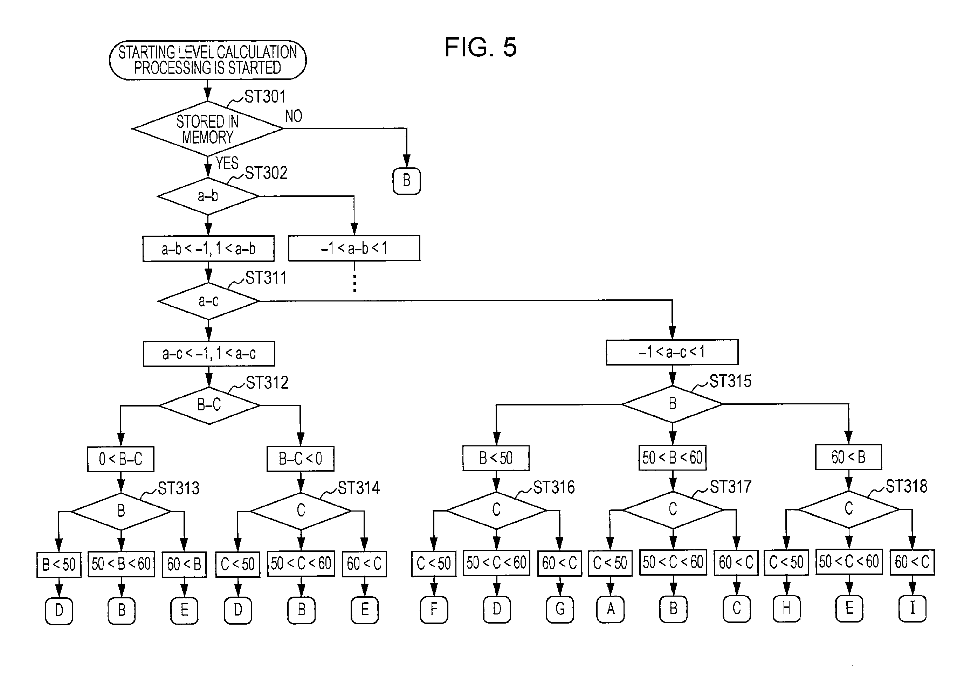

Next, the detail of the resetting processing for the starting level will be described. Fig. 3 is a flowchart mainly illustrating detection processing for the desired signal and the disturbing signal. Fig. 4 and Fig. 5 are flowcharts illustrating calculation processing for the starting level. Hereinafter, it is assumed that the level of the desired signal is A and the frequency thereof is a. In addition, it is assumed that a disturbing signal 1 whose level is B and whose frequency is b and a disturbing signal 2 whose level is C and whose frequency is c concurrently exit in the frequency band of the audio broadcast. In this regard, however, the desired signal and the disturbing signal are not limited to these. In addition, when a plurality of disturbing signals exist in the frequency band of the audio broadcast, it is desirable that two signals suitable for resetting the starting level are selected. In this case, for example, it is only necessary to compare the levels and the frequencies of the plural disturbing signals, select two signals having significant influences on the receiving sensitivity, and reset the starting level on the basis of these signals.

As illustrated in Fig. 3, the control unit 51 in the microcomputer 5 causes the memory 52 to store therein the level information of the desired signal, detected by the signal meter 35 in the audio broadcast receiver 3 in a state where the desired wave is received, and the frequency information of the desired signal, based on the set frequency of the PLL circuit 39 (Steps ST201 and ST202). After that, when the resetting processing for the starting level has been started, the control unit 51 reduces the amplification degree of the LNA 42 by 50 dBµV (Step ST203).

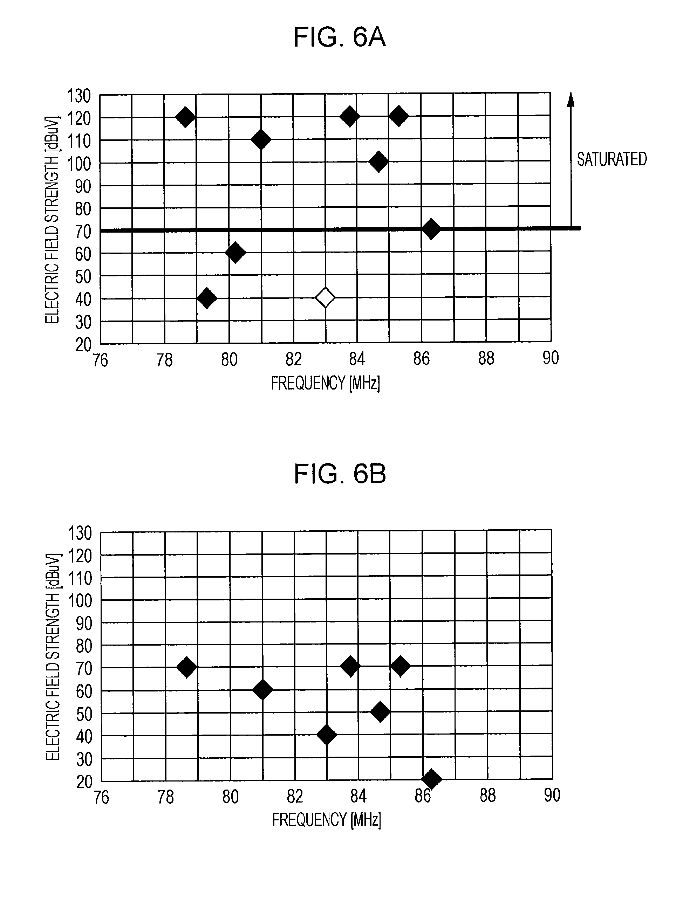

Figs. 6A and 6B are graphs illustrating relationships between the amplification degree of the LNA 42 and an electric field strength. The LNA 42 is configured so as to obtain a linear output in a range of up to 70 dBµV. Therefore, for example, as illustrated in Fig. 6A, when a high-level disturbing signal corresponding to 120 dBµV is input in setting (initial setting) performed at the time of the reception operation of the data broadcast, an output from the LNA 42 is saturated and becomes 70 dBµV. In this way, in a state where the amplification degree of the LNA 42 has been optimized for the reception operation of the data broadcast, it is difficult for the signal meter 45 in a subsequent stage to adequately detect the high-level disturbing signal.

Therefore, as illustrated in the above-mentioned Step ST203, the control unit 51 sets, in the LNA 42, an amplification degree lower than at the time of the reception operation of the data broadcast. Specifically, the amplification degree is reduced to the extent that the linearity is maintainable with respect to the assumed maximum signal level of the disturbing signal. For example, since, in a case in Fig. 6A, the disturbing signal is assumed to correspond to 120 dBµV at a maximum, it is only necessary to reduce the amplification degree by 50 dBµV so as to maintain the linearity of the LNA 42 (Fig. 6B). By reducing the amplification degree of the LNA 42 in such a way, it may be possible for the signal meter 45 to adequately detect the level of the disturbing signal even if the high-level disturbing signal is input.

Next, the control unit 51 sets the seek threshold of the stop determination unit 47 to 50 dBµV (Step ST204). Accordingly, it may become possible to detect a disturbing signal greater than or equal to 50 dBµV. Owing to the setting processing for the amplification degree of the LNA 42 (Step ST203) and the setting processing for the seek threshold of the stop determination unit 47 (Step ST204), the data broadcast receiver 4 shifts to a detection mode for the disturbing signal. In addition, a frequency position to be the starting point of a seek operation is set (Step ST205), and the seek operation is started (Step ST206). When the seek operation has been started, the stop determination unit 47 determines whether or not the signal-meter signal (level) from the signal meter 45 is greater than or equal to the seek threshold set in the stop determination unit 47 (Step ST207).

When the signal-meter signal (level) is greater than or equal to the seek threshold (Step ST207: YES), the stop determination unit 47 notifies the control unit 51 of that effect. In addition, the control unit 51 advises the stop determination unit 47 to acquire the IF count signal from the IF counting unit 46 (Step ST208). When the IF count signal has been acquired from the IF counting unit 46 (Step ST208: YES), the stop determination unit 47 notifies the control unit 51 of that effect.

The control unit 51 having received the notice causes the memory 52 to store therein the level information detected in the signal meter 45 and the frequency information based on the set frequency of the PLL circuit 49 (Steps ST209 and ST210). The control unit 51 waits until the seek operation is terminated (Step ST211), and causes the memory 52 to store therein the level information and the frequency information as necessary.

Next, the stop determination unit 47 determines whether or not a frequency has reached the band limit (upper limit or lower limit) of the frequency band of the audio broadcast (Step ST212). When the frequency has not reached the band limit (Step ST212: NO), the frequency of the local oscillation signal to be mixed in the mixer 43 is changed (Step ST213), and the seek operation is performed again using the changed frequency (Steps ST206 to ST213). In addition, when the level is not greater than or equal to the seek threshold (Step ST207: NO) or when the frequency information is not acquired from the IF counting unit 46 (Step ST208: NO), the frequency is changed (Step ST213).

When the frequency has reached the band limit of the frequency band of the audio broadcast (Step ST212: YES), the data broadcast receiver 4 halts the seek operation, and notifies the control circuit 51 of that effect (Step ST214). When the seek operation has been halted, the control circuit 51 starts the calculation processing for the starting level of the AGC circuit 37 (Step ST215). In addition, the control circuit 51 raises the amplification degree of the LNA 42 by 50 dBµV (Step ST216), and sets the seek threshold of the stop determination unit 47 to 25 dBµV (Step ST217). Accordingly, the data broadcast receiver 4 returns to a reception mode for the data broadcast. When the calculation processing for the starting level, described later, has been terminated, the control circuit 51 sets the starting level of the AGC circuit 37 in response to a calculation result (Step ST218).

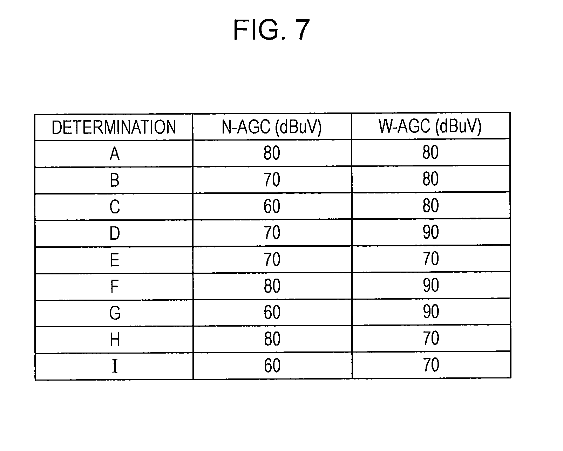

As illustrated in Fig. 4 and Fig. 5, when the calculation processing for the starting level of the AGC circuit 37 has been started, the control circuit 51 determines whether or not the level information and the frequency information of the disturbing signal have been stored in the memory 52 (Step ST301). When the level information and the frequency information of the disturbing signal have not been stored in the memory 52 (Step ST301: NO), the control circuit 51 sets the starting level on the basis of a pattern B. Fig. 7 is a table illustrating the pattern of a starting level to be set. As illustrated in Fig. 7, in the pattern B, the starting level of the N-AGC circuit is set to 70 dBµV, and the starting level of the W-AGC circuit is set to 80 dBµV.

When the level information and the frequency information of the disturbing signal have been stored in the memory 52 (Step ST301: YES), the control circuit 51 determines whether the disturbing signal 1 exists in the range of the W-AGC or exists in the range of the N-AGC. Specifically, a difference between the frequency a of the desired signal and the frequency b of the disturbing signal 1 is determined (Step ST302). When, in Step ST302, it has been determined that - 1 (MHz) < a - b < 1 (MHz) is satisfied, namely, when the disturbing signal 1 is in proximity to the desired signal, the control circuit 51 determines whether the disturbing signal 2 exists in the range of the W-AGC or exists in the range of the N-AGC. Specifically, as illustrated in Fig. 4, a difference between the frequency a of the desired signal and the frequency c of the disturbing signal 2 is determined (Step ST303).

When, in Step ST303, it has been determined that - 1 (MHz) < a - c < 1 (MHz) is satisfied, namely, when the disturbing signal 2 is in proximity to the desired signal, the control circuit 51 determines a difference between the level B of the disturbing signal 1 and the level C of the disturbing signal 2 (Step ST304).

When, in Step ST304, it has been determined that 0 < B - C is satisfied, namely, when the level of the disturbing signal 1 is higher than that of the disturbing signal 2, the level B of the disturbing signal 1 is determined (Step ST305). When B < 50 (dBµV) is satisfied, namely, the level of the disturbing signal 1 is low, the control circuit 51 sets the starting level on the basis of a pattern A. As illustrated in Fig. 7, in the pattern A, the starting level of the N-AGC circuit is set to 80 dBµV, and the starting level of the W-AGC circuit is set to 80 dBµV. When 50 (dBµV) < B < 60 (dBµV) is satisfied, namely, when the level of the disturbing signal 1 is a medium level, the control circuit 51 sets the starting level on the basis of the pattern B. When 60 (dBµV) < B is satisfied, namely, when the level of the disturbing signal 1 is high, the control circuit 51 sets the starting level on the basis of a pattern C. As illustrated in Fig. 7, in the pattern C, the starting level of the N-AGC circuit is set to 60 dBµV, and the starting level of the W-AGC circuit is set to 80 dBµV.

On the other hand, when, in Step ST304, it has been determined that B - C < 0 is satisfied, namely, when the level of the disturbing signal 2 is higher than that of the disturbing signal 1, the level C of the disturbing signal 2 is determined (Step ST306). When C < 50 (dBµV) is satisfied, namely, the level of the disturbing signal 2 is low, the control circuit 51 sets the starting level on the basis of the pattern A. When 50 (dBµV) < C < 60 (dBµV) is satisfied, namely, when the level of the disturbing signal 2 is a medium level, the control circuit 51 sets the starting level on the basis of the pattern B. When 60 (dBµV) < C is satisfied, namely, when the level of the disturbing signal 2 is high, the control circuit 51 sets the starting level on the basis of the pattern C.

In addition, when, in Step ST303, it has been determined that a - c < - 1 (MHz) or 1 (MHz) < a - c is satisfied, namely, when the disturbing signal 2 exists in a frequency position located away from the desired signal, the control circuit 51 determines the level B of the disturbing signal 1 (Step ST307).

When, in Step ST307, it has been determined that B < 50 (dBµV) is satisfied, namely, when the level of the disturbing signal 1 is low, the level C of the disturbing signal 2 is determined next (Step ST308). When C < 50 (dBµV) is satisfied, namely, when the level of the disturbing signal 2 is low, the control circuit 51 sets the starting level on the basis of a pattern F. As illustrated in in Fig. 7, in the pattern F, the starting level of the N-AGC circuit is set to 80 dBµV, and the starting level of the W-AGC circuit is set to 90 dBµV. When 50 (dBµV) < C < 60 (dBµV) is satisfied, namely, when the level of the disturbing signal 2 is a medium level, the control circuit 51 sets the starting level on the basis of the pattern A. When 60 (dBµV) < C is satisfied, namely, when the level of the disturbing signal 2 is high, the control circuit 51 sets the starting level on the basis of a pattern H. As illustrated in Fig. 7, in the pattern H, the starting level of the N-AGC circuit is set to 80 dBµV, and the starting level of the W-AGC circuit is set to 70 dBµV.

When, in Step ST307, it has been determined that 50 (dBµV) < B < 60 (dBµV) is satisfied, namely, when the level of the disturbing signal 1 is a medium level, the level C of the disturbing signal 2 is determined next (Step ST309). When C < 50 (dBµV) is satisfied, namely, the level of the disturbing signal 2 is low, the control circuit 51 sets the starting level on the basis of a pattern D. As illustrated in Fig. 7, in the pattern D, the starting level of the N-AGC circuit is set to 70 dBµV, and the starting level of the W-AGC circuit is set to 90 dBµV. When 50 (dBµV) < C < 60 (dBµV) is satisfied, namely, when the level of the disturbing signal 2 is a medium level, the control circuit 51 sets the starting level on the basis of the pattern B. When 60 (dBµV) < C is satisfied, namely, when the level of the disturbing signal 2 is high, the control circuit 51 sets the starting level on the basis of a pattern E. As illustrated in Fig. 7, in the pattern E, the starting level of the N-AGC circuit is set to 70 dBµV, and the starting level of the W-AGC circuit is set to 70 dBµV.

When, in Step ST307, it has been determined that 60 (dBµV) < B is satisfied, namely, when the level of the disturbing signal 1 is high, the level C of the disturbing signal 2 is determined next (Step ST310). When C < 50 (dBµV) is satisfied, namely, when the level of the disturbing signal 2 is low, the control circuit 51 sets the starting level on the basis of a pattern G. As illustrated in in Fig. 7, in the pattern G, the starting level of the N-AGC circuit is set to 60 dBµV, and the starting level of the W-AGC circuit is set to 90 dBµV. When 50 (dBµV) < C < 60 (dBµV) is satisfied, namely, when the level of the disturbing signal 2 is a medium level, the control circuit 51 sets the starting level on the basis of the pattern C. When 60 (dBµV) < C is satisfied, namely, when the level of the disturbing signal 2 is high, the control circuit 51 sets the starting level on the basis of a pattern I. As illustrated in Fig. 7, in the pattern I, the starting level of the N-AGC circuit is set to 60 dBµV, and the starting level of the W-AGC circuit is set to 70 dBµV.

When, in Step ST302, it has been determined that a - b < - 1 (MHz) or 1 (MHz) < a - b is satisfied, namely, when the disturbing signal 1 exists in a frequency position located away from the desired signal, the control circuit 51 determines whether the disturbing signal 2 exists in the range of the W-AGC or exists in the range of the N-AGC. Specifically, as illustrated in Fig. 5, a difference between the frequency a of the desired signal and the frequency c of the disturbing signal 2 is determined (Step ST311).

When, in Step ST311, it has been determined that a - c < - 1 (MHz) or 1 (MHz) < a - c is satisfied,, namely, when the disturbing signal 2 exists in a frequency position located away from the desired signal, the control circuit 51 determines a difference between the level B of the disturbing signal 1 and the level C of the disturbing signal 2 (Step ST312).

When, in Step ST312, it has been determined that 0 < B - C is satisfied, namely, when the level of the disturbing signal 1 is higher than that of the disturbing signal 2, the level B of the disturbing signal 1 is determined (Step ST313). When B < 50 (dBµV) is satisfied, namely, when the level of the disturbing signal 1 is low, the control circuit 51 sets the starting level on the basis of the pattern D. When 50 (dBµV) < B < 60 (dBµV) is satisfied, namely, when the level of the disturbing signal 1 is a medium level, the control circuit 51 sets the starting level on the basis of the pattern B. When 60 (dBµV) < B is satisfied, namely, when the level of the disturbing signal 1 is high, the control circuit 51 sets the starting level on the basis of the pattern E.

On the other hand, when, in Step ST312, it has been determined that B - C < 0 is satisfied, namely, when the level of the disturbing signal 2 is higher than that of the disturbing signal 1, the level C of the disturbing signal 2 is determined (Step ST314). When C < 50 (dBµV) is satisfied, namely, when the level of the disturbing signal 2 is low, the control circuit 51 sets the starting level on the basis of the pattern D. When 50 (dBµV) < C < 60 (dBµV) is satisfied, namely, when the level of the disturbing signal 2 is a medium level, the control circuit 51 sets the starting level on the basis of the pattern B. When 60 (dBµV) < C is satisfied, namely, when the level of the disturbing signal 2 is high, the control circuit 51 sets the starting level on the basis of the pattern E.

When, in Step ST311, it has been determined that - 1 (MHz) < a - c < 1 (MHz) is satisfied, namely, when the disturbing signal 2 is in proximity to the desired signal, the control circuit 51 determines the level B of the disturbing signal 1 (Step ST315).

When, in Step ST315, it has been determined that B < 50 (dBµV) is satisfied, namely, when the level of the disturbing signal 1 is low, the level C of the disturbing signal 2 is determined next (Step ST316). When C < 50 (dBµV) is satisfied, namely, the level of the disturbing signal 2 is low, the control circuit 51 sets the starting level on the basis of the pattern F. When 50 (dBµV) < C < 60 (dBµV) is satisfied, namely, when the level of the disturbing signal 2 is a medium level, the control circuit 51 sets the starting level on the basis of the pattern D. When 60 (dBµV) < C is satisfied, namely, when the level of the disturbing signal 2 is high, the control circuit 51 sets the starting level on the basis of the pattern G.

When, in Step ST315, it has been determined that 50 (dBµV) < B < 60 (dBµV) is satisfied, namely, when the level of the disturbing signal 1 is a medium level, the level C of the disturbing signal 2 is determined next (Step ST317). When C < 50 (dBµV) is satisfied, namely, the level of the disturbing signal 2 is low, the control circuit 51 sets the starting level on the basis of the pattern A. When 50 (dBµV) < C < 60 (dBµV) is satisfied, namely, when the level of the disturbing signal 2 is a medium level, the control circuit 51 sets the starting level on the basis of the pattern B. When 60 (dBµV) < C is satisfied, namely, when the level of the disturbing signal 2 is high, the control circuit 51 sets the starting level on the basis of the pattern C.

When, in Step ST315, it has been determined that 60 (dBµV) < B is satisfied, namely, when the level of the disturbing signal 1 is high, the level C of the disturbing signal 2 is determined next (Step ST318). When C < 50 (dBµV) is satisfied, namely, when the level of the disturbing signal 2 is low, the control circuit 51 sets the starting level on the basis of the pattern H. When 50 (dBµV) < C < 60 (dBµV) is satisfied, namely, when the level of the disturbing signal 2 is a medium level, the control circuit 51 sets the starting level on the basis of the pattern E. When 60 (dBµV) < C is satisfied, namely, when the level of the disturbing signal 2 is high, the control circuit 51 sets the starting level on the basis of the pattern I.

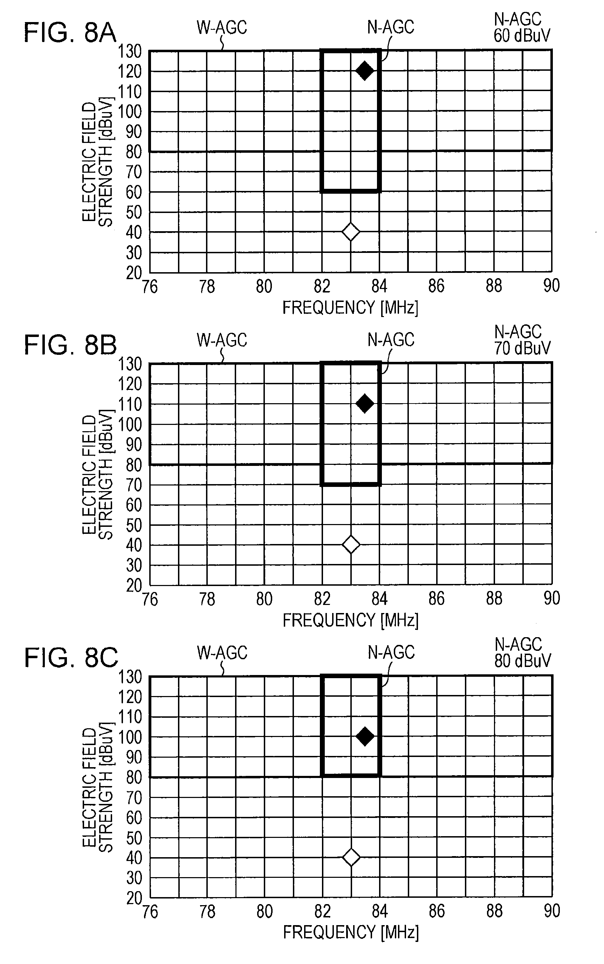

In this way, by setting the starting level of the AGC circuit 37 on the basis of the level information and the frequency information of the disturbing signal and the frequency information of the desired signal, it may be possible to enhance the performance to remove the disturbing signal. Figs. 8A to 8F are graphs illustrating relationships among the frequency and the level of a disturbing signal and the starting level of the AGC circuit. In each graph, the desired signal whose frequency is 83 MHz and whose level is 40 dBµV is illustrated. In addition, disturbing signals whose levels and frequencies differ from one graph to another are illustrated.

Fig. 8A corresponds to a state where a disturbing signal corresponding to slightly lower than 120 dBµV (the detection level of the signal meter 45 is slightly lower than 70 dBµV) exists in a range from 82 MHz to 84 MHz. In this case, the starting level of the N-AGC circuit is set to 60 dBµV, and the starting level of the W-AGC circuit is set to 80 dBµV (which corresponds to the pattern C in Fig. 7). In this way, when a high-level disturbing signal exists in the vicinity of the desired signal, setting the starting level of the N-AGC circuit low enables gain control in an early stage, and it may be possible to adequately suppress the high-level disturbing signal.

Fig. 8B corresponds to a state where a disturbing signal corresponding to slightly lower than 110 dBµV (the detection level of the signal meter 45 is slightly lower than 60 dBµV) exists in a range from 82 MHz to 84 MHz. In this case, the starting level of the N-AGC circuit is set to 70 dBµV, and the starting level of the W-AGC circuit is set to 80 dBµV (which corresponds to the pattern B in Fig. 7). In this way, when a medium-level disturbing signal exists in the vicinity of the desired signal, setting the starting level of the N-AGC circuit to a medium level enables adequate gain control, and it may be possible to suppress the disturbing signal without negatively affecting the desired signal.

Fig. 8C corresponds to a state where a disturbing signal corresponding to slightly lower than 100 dBµV (the detection level of the signal meter 45 is slightly lower than 50 dBµV) exists in a range from 82 MHz to 84 MHz. In this case, the starting level of the N-AGC circuit is set to 80 dBµV, and the starting level of the W-AGC circuit is set to 80 dBµV (which corresponds to the pattern A in Fig. 7). In this way, when a low-level disturbing signal exists in the vicinity of the desired signal, setting the starting level of the N-AGC circuit high enables adequate gain control, and it may be possible to suppress the disturbing signal without negatively affecting the desired signal.

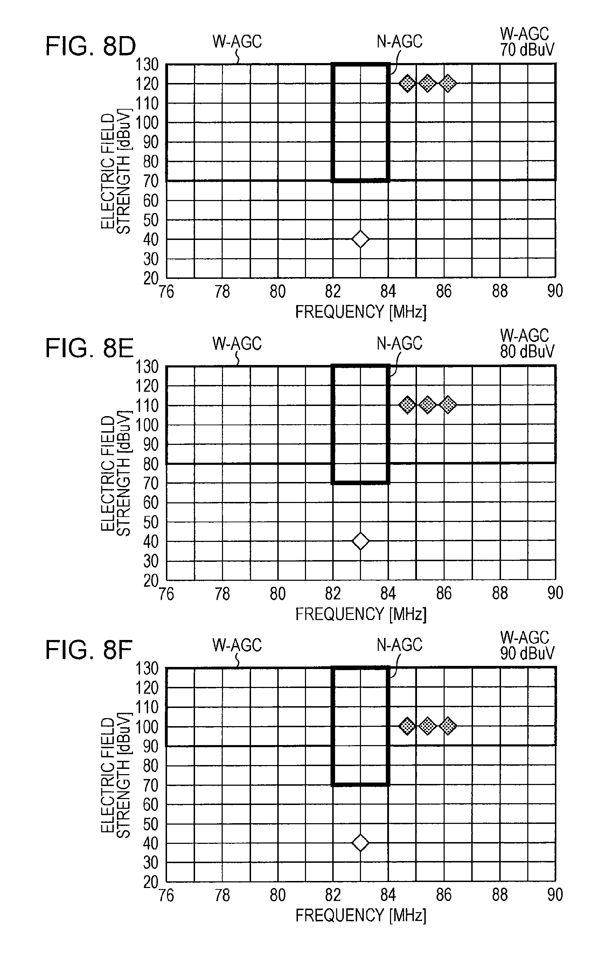

Fig. 8D corresponds to a state where a disturbing signal corresponding to slightly lower than 120 dBµV (the detection level of the signal meter 45 is slightly lower than 70 dBµV) exists in a frequency range higher than 84 MHz. In this case, the starting level of the N-AGC circuit is set to 70 dBµV, and the starting level of the W-AGC circuit is set to 70 dBµV (which corresponds to the pattern E in Fig. 7). In this way, when a high-level disturbing signal exists in a frequency position located a predetermined frequency or more away from the desired signal, setting the starting level of the W-AGC circuit low enables gain control in an early stage, and it may be possible to adequately suppress the high-level disturbing signal.

Fig. 8E corresponds to a state where a disturbing signal corresponding to slightly lower than 110 dBµV (the detection level of the signal meter 45 is slightly lower than 60 dBµV) exists in a frequency range higher than 84 MHz. In this case, the starting level of the N-AGC circuit is set to 70 dBµV, and the starting level of the W-AGC circuit is set to 80 dBµV (which corresponds to the pattern B in Fig. 7). In this way, when a medium-level disturbing signal exists in a frequency position located a predetermined frequency or more away from the desired signal, setting the starting level of the W-AGC circuit to a medium level enables adequate gain control, and it may be possible to suppress the disturbing signal without negatively affecting the desired signal.

Fig. 8F corresponds to a state where a disturbing signal corresponding to slightly lower than 100 dBµV (the detection level of the signal meter 45 is slightly lower than 50 dBµV) exists in a frequency range higher than 84 MHz. In this case, the starting level of the N-AGC circuit is set to 70 dBµV, and the starting level of the W-AGC circuit is set to 90 dBµV (which corresponds to the pattern D in Fig. 7). In this way, when a low-level disturbing signal exists in a frequency position located a predetermined frequency or more away from the desired signal, setting the starting level of the W-AGC circuit high enables adequate gain control, and it may be possible to suppress the disturbing signal without negatively affecting the desired signal.

As described above, in the broadcast reception device 1 according to the present embodiment, the data broadcast receiver (second tuner device) 4 is configured to detect the level and the frequency of the disturbing signal using the vacant time of the data broadcast receiver 4, it may be possible to adequately set the starting level (AGC starting level) of the AGC circuit 37 without putting a load on the audio broadcast receiver (first tuner device) 3. In addition, since the level of the disturbing signal is detected after the amplification degree of the data broadcast receiver 4 has been reduced by a predetermined amount, it may be possible to adequately detect the level of the disturbing signal and adequately set the starting level of the AGC circuit 37. From these results, it may be possible to enhance the performance to remove the disturbing signal.

In addition, in the broadcast reception device 1 according to the present embodiment, since the starting level of the AGC circuit 37 is set by comparing the magnitude of each of the levels and the frequencies of a plurality of disturbing signals, it may become possible to perform fine-tuned setting according to the state of the disturbing signal, and it may be possible to enhance the performance to remove the disturbing signal. In particular, two signals serving as a basis for setting the starting level of the AGC circuit 37 are selected from a plurality of disturbing signals, and, by comparing the magnitude of each of the levels and the frequencies thereof, the starting level of the AGC circuit 37 is set. Accordingly, since it may be possible to set the starting level on the basis of a disturbing signal suitable for setting the starting level of the AGC circuit 37, it may be possible to enhance the performance to remove the disturbing signal with reducing a load on the processing.

In addition, in the broadcast reception device 1 according to the present embodiment, since the amplification degree of the LNA (second amplifying device) 42 is reduced to a level where the linearity of the LNA 42 is maintainable with respect to the assumed maximum signal level of the disturbing signal, it may be possible to adequately detect the level of the disturbing signal with maintaining the linearity of the LNA 42. As a result, it may be possible to enhance the performance to remove the disturbing signal.

In addition, the present invention is not limited to the above-mentioned embodiment, and may be implemented with modifications being arbitrarily made in an embodiment where the advantageous effect thereof is exerted. For example, while, in the above-mentioned embodiment, a case has been exemplified where the starting level of the AGC circuit 37 is set on the basis of the two signals (disturbing signals 1 and 2), the starting level of the AGC circuit 37 may also be set using three or more signals. In addition, the patterns A to I used for setting the starting level in the above-mentioned embodiment are just examples, and the present invention is not limited to these.

A broadcast reception device of the present invention is useful as, for example, an in-car broadcast reception device.

## Claims

1. A broadcast reception device having a seek function of sweeping a reception target band and detecting a desired signal, the broadcast reception device comprising:
first and second tuner devices (3, 4), into each of which a reception signal from an antenna (2) is input; and a controller (5) controlling the first and second tuner devices (3, 4), wherein
the first tuner device (3) includes a first amplifying device (32) amplifying the reception signal from the antenna (2), a first frequency setting circuit (39) setting a frequency corresponding to a signal extracted from the reception signal, and an AGC circuit (37) controlling a level of the reception signal,
the second tuner device (4) includes a second amplifying device (42) amplifying the reception signal from the antenna (2), a second frequency setting circuit (49) setting a frequency corresponding to a signal extracted from the reception signal, and a level detection circuit (45) detecting the level of the reception signal,
the controller (5) includes a memory (52) storing therein a detection result of the level detection circuit (45) and storing therein set frequency values of the first and second frequency setting circuits (39, 49), and
under the control of the controller (5),
the memory (52) stores therein a frequency value of the desired signal, set by the first frequency setting circuit (39), in a state where the first tuner device (3) receives the desired signal,
the second tuner device (4) sweeps a reception target band and receives a disturbing signal different from the desired signal after an amplification degree of the second amplifying device (42) has been reduced by a predetermined amount, a level of the received disturbing signal is detected by the level detection circuit (45) and stored in the memory (52) along with a frequency value set by the second frequency setting circuit (49), and
an AGC starting level of the AGC circuit (37) is set on the basis of a magnitude of each of the level and a frequency of the disturbing signal.

2. The broadcast reception device according to claim 1, wherein
when a plurality of disturbing signals are detected, the AGC starting level of the AGC circuit (37) is set by comparing a magnitude of each of levels and frequencies of the plural disturbing signals.

3. The broadcast reception device according to claim 2, wherein
two signals serving as a basis for setting the AGC starting level of the AGC circuit (37) are selected in response to the levels and the frequencies of the plural disturbing signals, and the AGC starting level of the AGC circuit (37) is set by comparing a magnitude of each of the levels and the frequencies of the two disturbing signals.

4. The broadcast reception device according to any one of claim 1 to claim 3, wherein
the second tuner device (4) reduces the amplification degree of the second amplifying device (42) to a level where linearity of the second amplifying device (42) is maintainable with respect to an assumed maximum signal level of the disturbing signal.

5. The broadcast reception device according to any one of claim 1 to claim 4, wherein
the AGC circuit (37) includes a narrowband AGC circuit gain-controlling a disturbing signal existing in the vicinity of the desired signal and a wideband AGC circuit gain-controlling a disturbing signal located a predetermined frequency or more away from the desired signal, and
an AGC starting level is set for each of the narrowband AGC circuit and the wideband AGC circuit.

6. The broadcast reception device according to any one of claim 1 to claim 5, wherein
the broadcast reception device is configured to be able to receive FM broadcast.

7. The broadcast reception device according to any one of claim 1 to claim 6, wherein
the first tuner device (3) is a tuner device used for audio broadcast reception, and the second tuner device (4) is a tuner device used for data broadcast reception.
